(19) **Europäisches Patentamt**
**European Patent Office**
**Office européen des brevets**

(11) **EP 2 918 655 B1**

(12) **EUROPEAN PATENT SPECIFICATION**

(45) Date of publication and mention
of the grant of the patent:
**26.10.2016 Bulletin 2016/43**

(51) Int Cl.:
***C09K 11/61*** *(2006.01)*     *H01L 33/50* *(2010.01)*

(21) Application number: **14183718.7**

(22) Date of filing: **05.09.2014**

(54) **LIGHT EMITTING DEVICE**

LICHTEMITTIERENDE VORRICHTUNG

DISPOSITIF ÉLECTROLUMINESCENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.03.2014 JP 2014049086**
        **20.08.2014 JP 2014167554**

(43) Date of publication of application:
**16.09.2015 Bulletin 2015/38**

(73) Proprietor: **Kabushiki Kaisha Toshiba**
**Tokyo 105-8001 (JP)**

(72) Inventors:
• **Shimojuku, Miyuki**
**Tokyo, 105-8001 (JP)**

• **Furuyama, Hideto**
**Tokyo, 105-8001 (JP)**
• **Kojima, Akihiro**
**Tokyo, 105-8001 (JP)**
• **Ando, Masanobu**
**Tokyo, 105-8001 (JP)**
• **Akimoto, Yosuke**
**Tokyo, 105-8001 (JP)**

(74) Representative: **Hoffmann Eitle**
**Patent- und Rechtsanwälte PartmbB**
**Arabellastraße 30**
**81925 München (DE)**

(56) References cited:
**US-A1- 2003 006 469**    **US-A1- 2006 284 185**
**US-A1- 2007 247 829**    **US-A1- 2012 126 253**

**Description**

FIELD

Embodiments are related generally to a light emitting device.

BACKGROUND

Light emitting devices are developed by combining a light emitter such as a light-emitting diode with phosphors, wherein the phosphors are excited by light emitted from the light emitter, and emit light different in a wavelength from the excitation light. Such light emitting devices can realize a white light source, for example, by combining a blue light-emitting diode with a YAG phosphor. White light sources can be used in a wide range of applications, and however, are required to have different color rendering properties depending on each application. Hence, there is a demand for the light emitting device that has advantages in color controllability and productivity.
Patent Document 1: US 2003/006469 A1 describes a white-emitting luminescence conversion LED using a chlorosilicate phosphor which, in addition to Ca and Mg, contains a europium doping, and also a garnet phosphor of the rare earths, in particular Y and/or Tb. Patent Document 2: US 2007/247829 A1 describes LEDs having a low color temperature up to 5000 K, comprising a blue-emitting LED and, connected upstream thereof, two phosphors having a first phosphor from the class of the chliorosilicates and a second phosphor from the class of the nitridosilicates having the formula $(Ca,Sr)_2Si_5N_8:Eu$. Patent Document 3: US 2012/126253 A1 describes a phosphor blend for an LED light source comprising from about 25 to about 35 weight percent of a cerium-activated yttrium aluminum garnet phosphor, from about 5 to about 10 weight percent of a europium-activated strontium calcium silicon nitride phosphor, and from about 50 to about 75 weight percent of a europium-activated calcium magnesium chlorosilicate phosphor.
Patent document 4: US 2006/284185 A1 describes a light emitting device including a light emitting chip, and a phosphor through which a light emitting from the light emitting chip at least partially passes such that the light is converted into lights having at least two different wavelengths are emitted.

BRIEF DESCRIPTION OF THE DRAWINGS

FIG. 1 is a schematic cross-sectional view showing a light emitting device according to a first embodiment;
FIGS. 2A to 4 are graphs showing characteristics of a phosphor according to the first embodiment;
FIGS. 5A and 5B are schematic views showing an emission spectrum of the light emitting device according to the first embodiment;
FIGS. 6A to 12B are schematic cross-sectional views showing a manufacturing process of the light emitting device according to the first embodiment;
FIG. 13 is a schematic cross-sectional view showing a light emitting device according to a second embodiment;
FIGS. 14A and 14B are schematic views showing a light emitting device according to a third embodiment; and
FIG. 15 is a schematic view showing another emission spectrum of the light emitting device according to the first embodiment.

DETAILED DESCRIPTION

According to an embodiment, a light emitting device includes a light emitter having an emission peak in a wavelength range of not less than 360 nanometers and not more than 470 nanometers, and a first phosphor having a composition represented by the chemical formula of $Ca_{8-x}Eu_xMg_{1-y}Mn_y(SiO_4)_4Cl_2$ ($0 < x \leq 8$, $0 < y \leq 1$).
Embodiments will be described below with reference to the accompanying drawings. In the appended figures, like elements are given the same reference numerals. Detailed descriptions of the same elements will be omitted as appropriate, and only the differences will be described. The figures are schematic and conceptual, and do not necessarily represent the actual elements with regard to variables such as thickness and width relationship, and the size proportions of elements. Further, the figures may represent the same elements in different dimensions and proportions.

First Embodiment

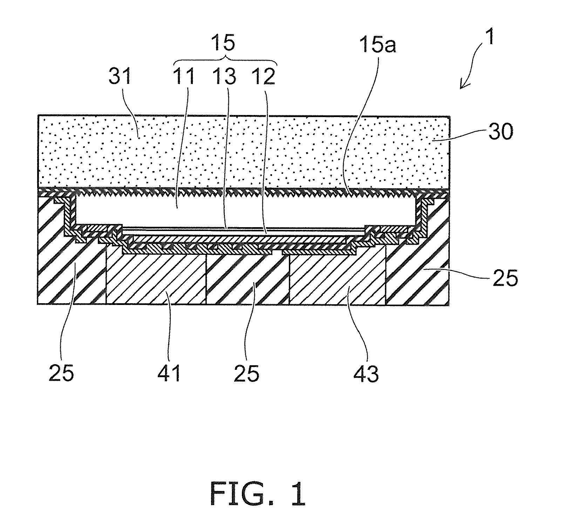

FIG. 1 is a schematic cross sectional view illustrating a light emitting device 1 according to a first embodiment.
The light emitting device 1 includes a stacked body 15, and a phosphor layer 30 provided on a light emitting surface 15a of the stacked body 15.
The stacked body 15 includes, for example, an n-type semiconductor layer 11, a p-type semiconductor layer 12, and a light emitting layer 13. The light emitting layer 13 is provided between the n-type semiconductor layer 11 and the p-type semiconductor layer 12. The stacked body 15 acts as a light emitter that emits the light from the light emitting layer 13.
A resin layer 25, a p-side interconnect electrode 41, and an n-side interconnect electrode 43 are provided on the surface of the stacked body 15 opposite to the light emitting surface 15a. The p-side interconnect electrode 41 is provided through the resin layer 25, and is electrically connected to the p-type semiconductor layer 11. The n-side interconnect electrode 43 is provided through the resin layer 25, and is electrically connected to the n-type semiconductor layer 12.

Voltage applied across the p-side interconnect electrode 41 and the n-side interconnect electrode 43 supplies current to the stacked body, and causes the light emitting layer 13 to emit light. The light emitted from the light emitting layer 13 is radiated outward from the stacked body 15.

The phosphor layer 30 is, for example, a resin layer, and includes a first phosphor (hereinafter, "phosphor 31"). The first phosphor 31 is excited by light emitted from the stacked body 15, and emits light having a wavelength different from the wavelength of light emission in the light emitting layer 13.

The light radiated from the light emitting device 1 is a mixture of the light radiated outward from the stacked body 15 through the phosphor layer 30, and the light emitted from the phosphor 31.

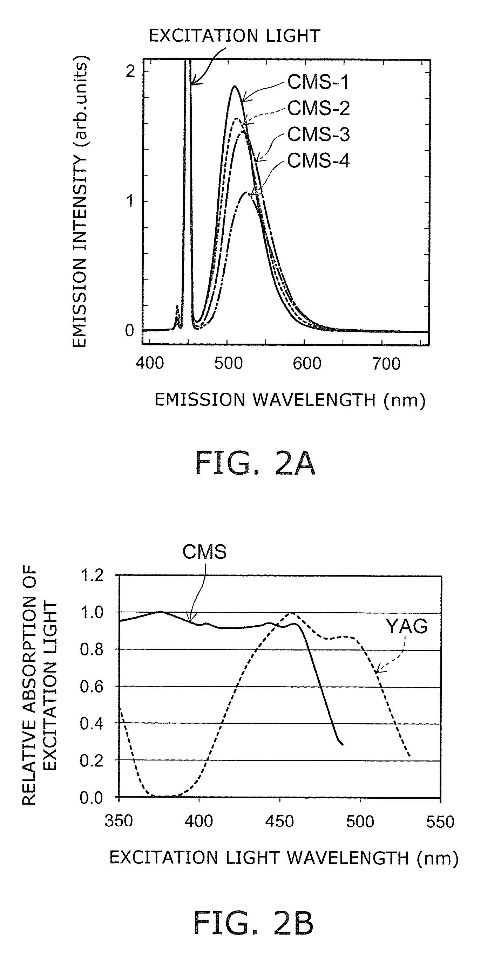

The characteristics of the phosphor 31 are described below with reference to FIG. 2A to FIG. 4, and FIG. 15.

FIGS. 2A and 2B are graphs showing the characteristics of the phosphor 31 according to First Embodiment.

FIG. 2A shows the emission spectra of the phosphor 31. The horizontal axis represents emission wavelength, and the vertical axis represents emission intensity (arbitrary unit).

FIG. 2B shows the excitation spectrum of the phosphor 31. The horizontal axis represents a wavelength of the excitation light, and the vertical axis represents relative absorption of the excitation light.

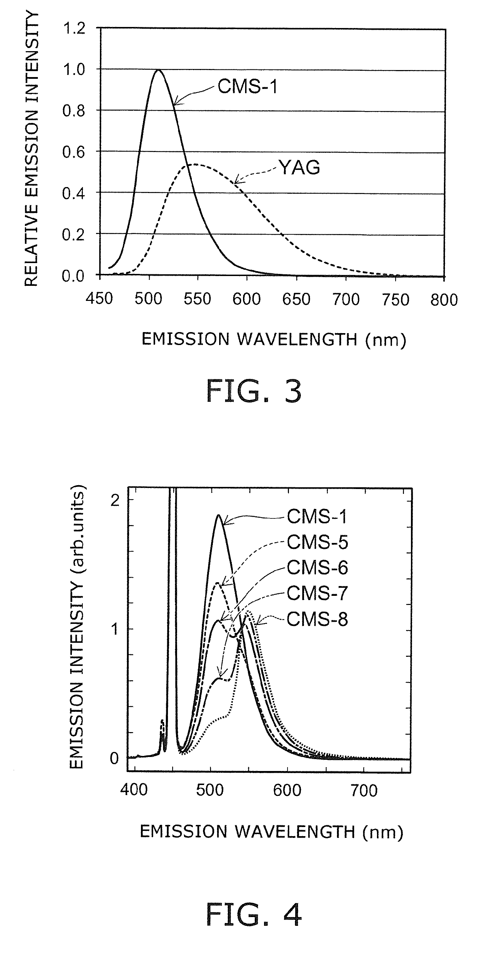

FIG. 3 is a graph comparing the emission spectra of the phosphor 31 and a YAG phosphor. The horizontal axis represents a wavelength of the emission light, and the vertical axis represents relative emission intensity.

The phosphor 31 is represented by the chemical formula $Ca_{8-x}Eu_xMg_{1-y}Mn_y(SiO_4)_4Cl_2$ ($0 < x \leq 8$, $0 < y \leq 1$), and is obtained by adding Eu to calcium magnesium chlorosilicate (hereinafter, "CMS phosphor"). The proportion y of manganese (Mn) is desirably in the range of $0 \leq y \leq 0.2$.

FIG. 2A shows the emission spectra of CMS phosphors containing europium (Eu) in different contents.

The chemical formulae of the CMS phosphors shown in FIG. 2A, and the wavelength of emission peak corresponding to each composition is determined as follows.

CMS 1: $Ca_{7.8}Eu_{0.2}Mg(SiO_4)_4Cl_2$, $\lambda p$ = 508.6 nm
CMS 2: $Ca_{7.6}Eu_{0.4}Mg(SiO_4)_4Cl_2$, $\lambda p$ = 512.3 nm
CMS 3: $Ca_{7.4}Eu_{0.6}Mg(SiO_4)_4Cl_2$, $\lambda p$ = 519.7 nm
CMS 4: $Ca_{7.2}Eu_{0.8}Mg(SiO_4)_4Cl_2$, $\lambda p$ = 524.6 nm

(CMS1 to CMS4 do not represent a first phosphor as comprised in the claimed light emitting device)

The emission peak wavelength $\lambda p$ of the CMS phosphor shifts towards the longer wavelength side with increase in the proportion of europium (Eu) in the composition.

FIG. 2B shows the excitation light absorption characteristic of the CMS phosphor (i.e. wavelength dependence thereof). The graph also shows the excitation light absorption characteristic of a YAG phosphor for comparison.

The CMS phosphor absorbs light of 480 nm or shorter wavelengths, and emits fluorescence in a wavelength range of 490 nm to 650 nm, wherein absorption of the excitation light may increase as approaching a wavelength of 370 nm from 450 nm in the composition range described above. Owing to small self-absorption, the CMS phosphor has high radiation efficiency. The emission peak intensity of the CMS phosphor may be at least twice as high as that of the YAG phosphor, as shown in FIG. 3.

By comparing the excitation light absorption characteristics of the CMS phosphor and the YAG phosphor, the CMS phosphor exhibits smaller change of absorptance than the YAG phosphor, which depends on a wavelength of the excitation light. The absorptance change is particularly smaller in the wavelength range of 460 nm or less, and the emission intensity also exhibits only a small change as varying excitation wavelengths in this wavelength range.

FIG. 4 is a graph showing the characteristics of other examples of the phosphor 31 according to First Embodiment.

The phosphors 31 shown in FIG. 4 are CMS phosphors having the compositions in which the constituent magnesium (Mg) is partially substituted with manganese (Mn). The chemical formulae of the CMS phosphors 5 to 8 shown in FIG. 4, and the wavelengths of the corresponding emission peaks of these compositions are as follows.

CMS 5: $Ca_{7.8}Eu_{0.2}Mg_{0.98}Mn_{0.02}(SiO_4)_4Cl_2$, $\lambda p$ = 507.4 nm
CMS 6: $Ca_{7.8}Eu_{0.2}Mg_{0.95}Mn_{0.05}(SiO_4)_4Cl_2$, $\lambda p$ = 508.6 nm
CMS 7: $Ca_{7.8}Eu_{0.2}Mg_{0.9}Mn_{0.1}(SiO_4)_4Cl_2$, $\lambda p$ = 546.7 nm
CMS 8: $Ca_{7.8}Eu_{0.2}Mg_{0.8}Mn_{0.2}(SiO_4)_4Cl_2$, $\lambda p$ = 548 nm

As shown above, the CMS phosphor may vary its emission peak wavelength even with the partial substitution of magnesium (Mg) with manganese (Mn).

The phosphor 31 may thus absorb, for example, the excitation light of 450 nm wavelength, and emit fluorescence having the intensity peak in a wavelength range of 500 nm to 555 nm. The luminosity curve of human has a maximum value at the light wavelength of 555 nm, and the phosphor 31 has the emission peak on the shorter wavelength side from the light wavelength at which the luminosity factor becomes maximum value.

As described above, the inventors have found that the CMS phosphor with the chemical formula $Ca_{8-x}Eu_xMg_{1-y}Mn_y(SiO_4)_4Cl_2$ ($0 < x \leq 8$, $0 < y \leq 1$) exhibits only a small change of absorptance in the wavelength range of 460 nm or less, and it is possible to suppress a variation of the emission intensity in the light emitting device 1 due to a wavelength change of the excitation light in the range of 460 nm or less, when the CMS phosphor is used as the phosphor 31. This means that when combining the phosphor 31 with a blue light-emitting diode, the light emitting device 1 may exhibits the stable emission characteristics, absorbing the emission wavelength variation of the blue light-emitting diode originated in manufacturing process. Thus, it may become possible to improve the productivity and the yield of the light emitting device. The emission wavelength of the blue light-emitting diode is preferably in the range of 365 nm to 470 nm. Down to the shortest wavelength of 365 nm, $In_xGa_{1-x}N$ ($0 \leq x \leq 1$) may keep high-efficiency of the blue light emission, and the CMS phosphor may absorb the excitation light up to the wavelength of 470 nm. Considering low-temperature operations, it is preferable for a high-efficiency light emitting device to use a blue light-emitting diode that emits light in the wavelength range of 360 nm to 470 nm.

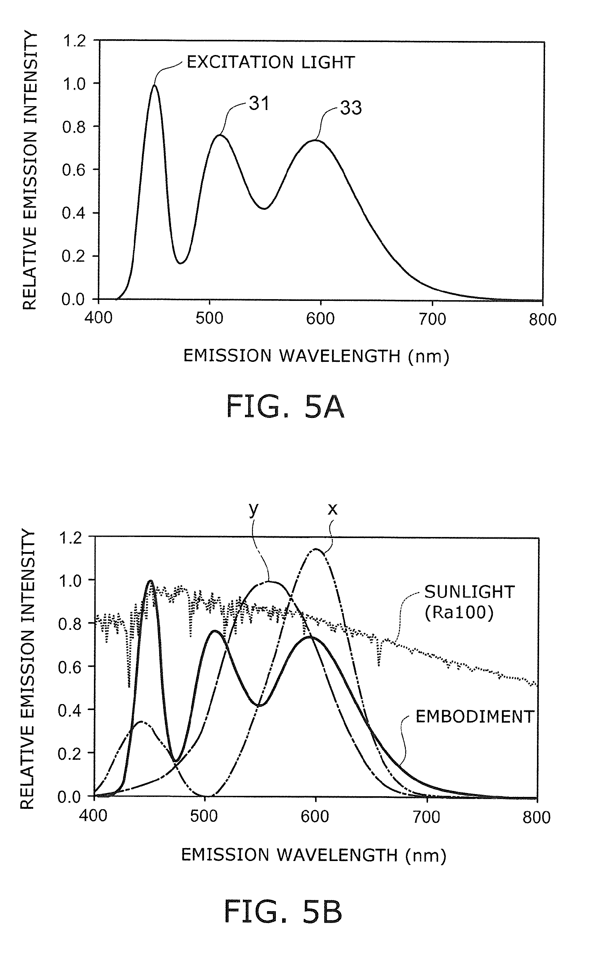

The structure and the manufacturing method of the light emitting device 1 are described below in detail with reference to FIG. 5A to FIG. 12B.

FIG. 5A is a graph showing an exemplary emission spectrum of the light emitting device 1 according to the first embodiment. In this example, the stacked body 15 is a blue light-emitting diode having the emission peak at the wavelength of 450 nm. In addition to the phosphor 31, the phosphor layer 30 includes a second phosphor (hereinafter, phosphor 33) that is excited by light radiated from the stacked body 15, and, in some cases, partially by the fluorescence of the phosphor 31. The phosphor 33 emits light having the emission peak on the longer wavelength side than the emission peak wavelength of the phosphor 31. In this way, a white light source can be realized with a desired color temperature.

Referring to FIG. 5A, the phosphor 33 is, for example, an orange phosphor having the emission peak in the wavelength range of 580 nm to 600 nm. The emission spectrum shown in FIG. 5A includes the emission peak of phosphor 31 in the wavelength range of blue green color and the emission peak of the phosphor 33 in the wavelength range of orange color in addition to the emission peak of excitation light in the blue light range. The emission peaks of phosphors 31 and 33 locate on both sides of the peak at the wavelength of 555 nm in the luminosity curve of human. As shown in FIG. 5B, this makes it possible to achieve brightness by the spectral components that locate on both sides of the peak within a range of the luminosity curve that is equivalent to the isochromatic curve y in the xyz isochromatic curves, and to ensure high degree of color rendition with the relatively broad emission spectrum that is close to the sunlight spectrum (color rendering index Ra = 100) broader than the luminosity curve. This makes it easier to satisfy both requirements for higher emission efficiency and higher level color rendition as compared to the conventional phosphors having emission peaks in the green to yellow range. As mentioned above, it becomes easier to achieve the high emission efficiency and the high level of color rendition by combining the CMS phosphor, which has high phosphor efficiency and the emission peak in the wavelength range of 508 to 520 nm, with the orange phosphor having the emission peak in the wavelength range of 580 to 600 nm. Furthermore, owing to the high-efficiency emission peak of the CMS phosphor in the wavelength range of 508 to 520 nm, which locates in the valley of the spectrum corresponding to the color-matching function x, this combination has an advantage in adjusting the chromaticity of white light (i.e. x and y coordinates in the CIE color space). When the y coordinate that contributes to brightness is shifted by adjusting the CMS phosphor, the x coordinate may exhibit less susceptibility to the y coordinate shift. Thus, this combination has large flexibility in the spectrum design.

In the conventional phosphor having an emission peak in the light wavelength range of green to yellow, the emission peak may coincide with the peak of the isochromatic curve y. Hence, adjusting the brightness (i.e. y coordinate) inevitably induces the change of x coordinate, making the adjustable range of chromaticity and brightness narrower. Thus, it is difficult for the phosphor having an emission peak in the green to yellow range to improve brightness while maintaining chromaticity. Further, red light is necessary in a white light spectrum using the conventional phosphor, to improve color rendition. The red light may include a large spectral component outside the isochromatic curve y that is equivalent to the human luminosity curve, and has less contribution to brightness. When using the CMS phosphor, it is possible to make most of phosphor spectrum contribute to high luminosity emission, while maintaining high level rendition. Thus, the light emitting device using the CMS phosphor may exhibit high level color rendition and high emission efficiency.

As described above, it is possible with the CMS phosphor to adjust the integral amount of the isochromatic curve y almost independently from the isochromatic curve x. This makes it possible to ensure the integral amount of the isochromatic curve y for high brightness, and to adjust chromaticity while maintaining high brightness and high level color rendition. That is, chromaticity can be flexibly adjusted with maintaining high brightness and high level color rendition. Thereby, the white light source may be achieved with high brightness and high level color rendition.

The embodiment is not limited to the light emitting device 1 having the emission spectrum shown in FIGS. 5A and 5B, and a red phosphor, a yellow phosphor, or a green phosphor, or a mixture thereof each cited below may be used for the phosphor 33.

The orange to red phosphors may contain, for example, at least one of a nitride phosphor $CaAlSiN_3:Eu$, a $(Ba,Sr)_3SiO_5:Eu$ phosphor, a $(Ba,Sr)_3(Si,Ge)O_5:Eu$ phosphor or a solid solution thereof with Al, and a sialon phosphor.

For example, the light emitting device 1 having high brightness and high level color rendition may be achieved by the phosphor layer 30 containing single-phase crystals of $(Ba,Sr)_3SiO_5:Eu$ or $(Ba,Sr)_3(Si,Ge)O_5:Eu$, and the CMS phosphor.

Alternatively, a phosphor of strontium silicate system, which is represented by the chemical formula of $(Sr_{1-x-y}Ba_yEu_x)_3(Si_{1-z}Ge_z)O_5$ ($0 < x \leq 0.1$, $0 \leq y \leq 1$, $0 \leq z \leq 0.1$), may be used for the phosphor layer 30. Specifically, a $(Sr_{0.97}Eu_{0.03})_3SiO_5$ phosphor, which has an emission peak at a wavelength of 580 nm, or a $(Sr_{0.845}Ba_{0.125}E_{0.30})_3SiO_5$ phosphor, which has an emission peak at a wavelength of 600 nm, may be referred to as examples.

The strontium silicate phosphors described above do not absorb the light emitted from the CMS phosphor, and thus, make it possible to achieve a light source which has higher light emission efficiency, and exhibits higher level color rendition than those in the case using the nitride phosphor $CaAlSiN_3:Eu$, which absorbs the light emitted from the CMS phosphor.

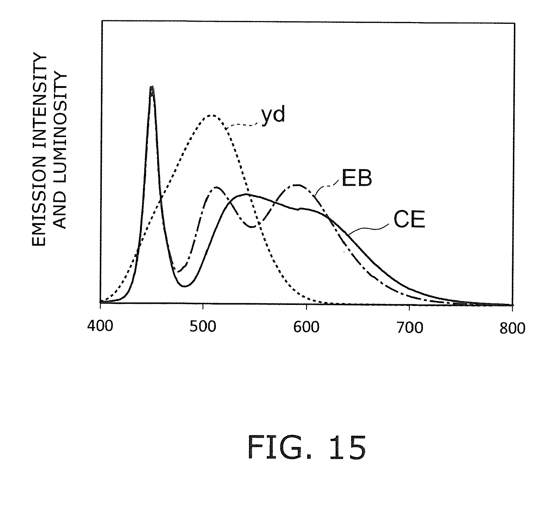

FIG. 15 is a graph showing an emission spectrum EB of the light emitting device 1. FIG. 15 also includes an emission spectrum CE of a light emitting device according to a relative example, wherein the YAG phosphor is used, and the dark-field luminosity curve yd.

The emission spectrum EB shown in FIG. 15 includes a blue light of wavelength 450 nm and emissions of CMS phosphor and strontium silicate phosphor, wherein the emission spectrum of the CMS phosphor includes an emission peak at the wavelength of 512 nm, and the emission spectrum of the strontium silicate phosphor includes an emission peak 580 nm. The light emitting device 1 with the emission spectrum EB exhibits the color rendering index Ra of 90. The emission spectrum CE includes a blue light of wavelength 450 nm and an emission of YAG phosphor, wherein the emission spectrum of the YAG phosphor includes a broad peak in the wavelength range of 530 nm~620 nm. The light emitting device with the emission spectrum CE exhibits Ra of 80. Thus, combining the CMS phosphor and strontium silicate phosphor provides higher Ra than the YAG phosphor.

The dark-field luminosity curve yd shown in FIG. 15 has a luminosity peak at a wavelength of 507 nm. The emission peak wavelength of the CMS phosphor locates in vicinity of the luminosity peak wavelength in the luminosity curve yd. Thus, it becomes possible by using CMS phosphor to achieve a light emitting device that provides brighter feeling in the dark field. Such a device may be advantageous in use of the street and tunnel.

The sialon phosphor is represented by, for example, the chemical formula $(M_{1-x},R_x)_{a1}AlSi_{b1}O_{c1}N_{d1}$. Here, M is at least one metal element excluding Si and Al, and is preferably at least one of Ca and Sr. R is the emission center element, and is preferably, for example, Eu. The symbols of x, a1, b1, c1, and d1 satisfy the following relations.

$$0 < x \leq 1;$$

$$0.6 < a1 < 0.95;$$

$$2 < b1 < 3.9;$$

$$0.25 < c1 < 0.45;$$

and

$$4 < d1 < 5.7$$

The phosphor used in the color range of orange to red is not limited to ones described above. For example, it may be possible to use phosphors represented by a chemical formula such as $CaS:Eu^{2+}$, $LiEuW_2O_8$, $SrO:Eu^{2+}$, $3.5Mg0.5MgF_2Ge_2:Mn$ or the like.

The yellow phosphor may contain, for example, at least one of YAG phosphor, silicate phosphor $(Sr,Ca,Ba)_2SiO_4:Eu$, $La_3Si_6N_{11}:Ce^{3+}$ phosphor, $Li_2SrSiO_4:Eu$, and BOSE phosphor $(Ba,Sr)_2SiO_4:Eu$.

For example, a light emitting device with Ra of 82 and a color temperature of 5000 K(Kelvin) may be achieved by using YAG phosphor and the CMS phosphor (e.g. $\lambda p$ = 512 nm), and exciting them by a blue light having a wavelength of 450 nm, wherein the YAG phosphor is represented by a chemical formula of $(Y_{1-x}A_x)_3(Al_{1-x}By)_5(O_{1-z}C_z)_{12}$ ($0 \leq x < 1$, $0 \leq y < 1$, $0 \leq z < 1$), wherein A is one element selected from a group of Tb, Gd, Sm, La, Sr, Ba, Ca and Mg; B is one element selected from a group of Si, Ge, B, P and Ga; and C is one element selected from a group of F, Cl, N and S. The composition rates of x, y and z are preferably in the ranges of $0 \leq x < 1$, $0.01 \leq y < 0.2$, $0.001 \leq z < 0.2$.

The green phosphor may contain, for example, at least one of halophosphate phosphor $(Ba,Ca,Mg)_{10}(PO_4)_6 \cdot Cl_2:Eu$, silicate phosphor $(Sr-Ba)_2SiO_4:Eu$, YAG phosphor $Y_3Al_5O_{12}:Ce$, LAG phosphor $Lu_3Al_5O_{12}:Ce$, and sialon phosphor.

For example, a light emitting device with Ra of 81 and a color temperature of 5000 K(Kelvin) may be achieved by using LAG phosphor, the nitride phosphor

CaAlSiN$_3$:Eu (e.g. $\lambda$p = 640 nm) and the CMS phosphor (e.g. $\lambda$p = 512 nm), and exciting them by a blue light having a wavelength of 450 nm, wherein the LAG phosphor is represented by a chemical formula of $(Lu_{1-x}A_x)_3(Al_{1-x}By)_5(O_{1-z}C_z)_{12}$ ($0 \leq x < 1$, $0 \leq y < 1$, $0 \leq z < 1$), wherein A is one element selected from a group of Y, Tb, Gd, Sm, La, Sr, Ba, Ca and Mg; B is one element selected from a group of Si, Ge, B, P and Ga; and C is one element selected from a group of F, Cl, N and S. The composition rates of x, y and z are preferably in the ranges of $0 \leq x < 1$, $0.01 \leq y < 0.2$, and $0.001 \leq z < 0.2$.

The sialon phosphor is represented by, for example, the chemical formula $(M_{1-x},R_x)_{a2}AlSi_{b2}O_{c2}N_{d2}$. Here, M is at least one metal element excluding Si and Al, and is preferably at least one of Ca and Sr. R is the emission center element, and is preferably, for example, Eu. The symbols of x, a2, b2, c2, and d2 satisfy the following relations.

$$0 < x \leq 1;$$

$$0.93 < a2 < 1.3;$$

$$4.0 < b2 < 5.8;$$

$$0.6 < c2 < 1;$$

and

$$6 < d2 < 11$$

As another example, the peak wavelength of the light radiated from the stacked body 15 may be shorter than 360 nm. It is also favorable in this case to dispose a phosphor that has an emission peak on the longer wavelength side than the peak wavelength of 550 nm in the human luminosity curve.

When the excitation light wavelength is shorter than 430 nm, the light emitting device 1 may lack blue light in the emission spectrum. It is therefore desirable to add a blue phosphor (third phosphor) having an emission peak in a wavelength range of 430 nm to 480 nm. For example, an oxide phosphor such as BaMgAl$_{10}$O$_{17}$:Eu and Sr$_3$MgSi$_2$O:Eu, (Sr,Ca,Ba,Mg)$_5$(PO$_4$)$_3$Cl:Eu, (Sr,Ca,Ba,Mg)$_{10}$(PO$_4$)$_6$Cl$_2$:Eu or the like may be used for the third phosphor.

It is also favorable to use red, yellow, and green phosphors that have high excitation efficiency in a wavelength range shorter than 360 nm.

Such a red phosphor is, for example, Y$_2$O$_3$:Eu, (Y,Gd)BO$_3$:Eu, Y$_2$O$_2$S:Eu, Gd$_2$O$_2$S:Eu, La$_2$O$_2$S:Eu, (Sr-Ba)$_3$MgSi$_2$O$_8$:EuMn, 3.5MgO·0.5MgF$_2$.GeO$_2$:Mn, or LiEuW$_2$O$_8$.

The yellow phosphor is, for example, (Ca,Sr)$_5$(PO$_4$)$_3$Cl:EuMn, (Sr,Ba)$_3$MgSi$_2$O$_8$:EuMn, or Zn$_2$GeO$_4$:Mn.

The green phosphor is, for example, (Ca,Sr)$_5$(PO$_4$)$_3$Cl:EuMn, BaMgAl$_{10}$O$_{17}$:EuMn, LaAl(SiAl)$_6$N$_9$O:Ce, (SrBa)$_3$MgSi$_2$O$_8$:EuMn, LaPO$_4$:Ce-Tb, or CeMgAl$_{11}$O$_{19}$:Tb.

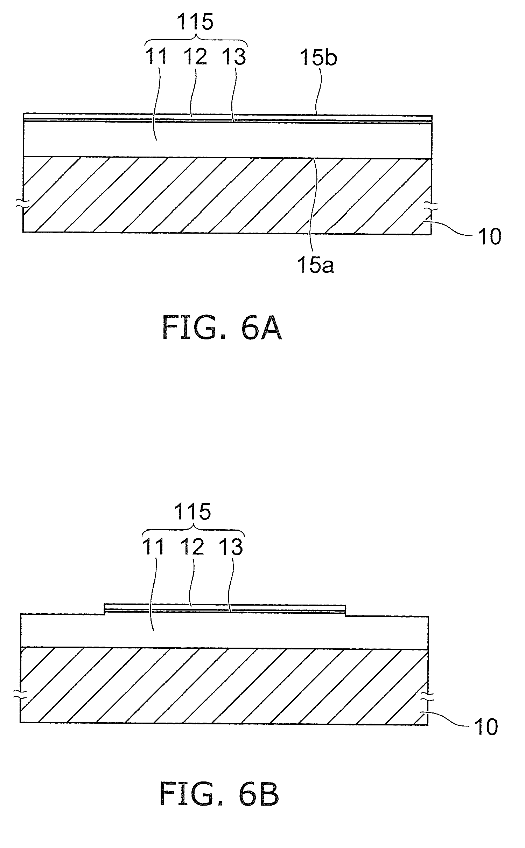

A method for manufacturing the light emitting device of the embodiment is described below with reference to FIG. 6A to FIG. 12B. FIG. 6A to FIG. 12B are schematic cross sectional views showing a manufacturing process of the light emitting device according to the first embodiment.

As shown in FIG. 6A, the n-type semiconductor layer 11 (first semiconductor layer), the light emitting layer 13, and the p-type semiconductor layer 12 (second semiconductor layer) are epitaxially grown in this order on the major surface of a substrate 10 by using, for example, MOCVD (metal organic chemical vapor deposition). Thereby, a semiconductor layer 115 is formed on the substrate 10, wherein the semiconductor layer 115 includes the n-type semiconductor layer 11, the light emitting layer 13, and the p-type semiconductor layer 12. A surface of the semiconductor layer 115 on the substrate 10 side is a first surface 15a, and a surface opposite thereto is a second surface 15b. The first surface 15a is also described as a light emitting surface.

The substrate 10 is, for example, a silicon substrate. Alternatively, the substrate 10 may be a sapphire substrate, or a silicon carbide (SiC) substrate. The semiconductor layer 115 is, for example, made of nitride semiconductors such as Group III nitride compound semiconductor.

The n-type semiconductor layer 11 includes, for example, a buffer layer provided on the major surface of the substrate 10, and an n-type GaN layer provided on the buffer layer. The p-type semiconductor layer 12 may include, for example, a p-type AlGaN layer provided on the light emitting layer 13, and a p-type GaN layer provided on the p-type AlGaN layer. The light emitting layer 13 has, for example, an MQW (multiple quantum well) structure. The light emitting layer 13 emits light having an emission peak, for example, in the wavelength range of 360 nm to 470 nm. The light emitting layer 13 may emits light having an emission peak, for example, in the wavelength range of 360 nm or less.

FIG. 6B shows the semiconductor layer 115 after selectively removing the p-type semiconductor layer 12 and the light emitting layer 13. For example, the p-type semiconductor layer 12 and the light emitting layer 13 are selectively etched by RIE (reactive ion etching) to expose the n-type semiconductor layer 11.

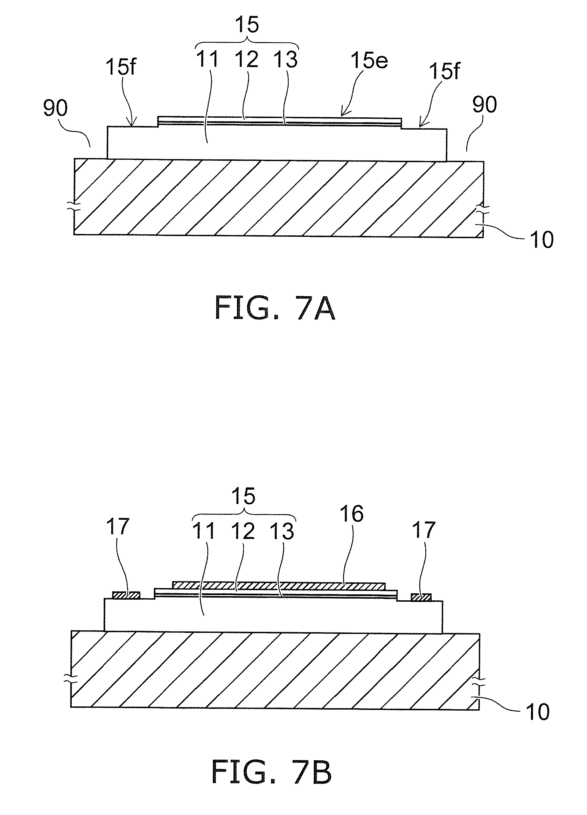

As shown in FIG. 7A, the n-type semiconductor layer 11 is selectively removed to form a trench 90. The trench 90 divides the semiconductor layer 115 into a plurality of stacked bodies 15 on the substrate 10. The stacked bodies 15 each serve as a light emitter including the light emitting layer 13. The trench 90 is formed, for example, in a shape of grid (not illustrated).

The trench 90 is formed through the semiconductor layer 115, and reaches to the substrate 10. The substrate 10 may also be etched so that the bottom of the trench 90 locates at lower level than the interface between the substrate 10 and the semiconductor layer 115. The trench 90 may be formed after forming a p-side contact electrode 16 and an n-side electrode 17.

The p-side electrode 16 is formed on the p-type semiconductor layer 12, as shown in FIG. 7B. The n-side electrode 17 is formed on a portion of the n-type semiconductor layer 11 where the p-type semiconductor layer 12 and the light emitting layer 13 have been selectively removed.

The p-side electrode 16 formed on the p-type semiconductor layer 12 may include a reflecting material that reflects the light emitted from the light emitting layer 13. For example, the p-side electrode 16 includes silver, silver alloy, aluminum, aluminum alloy, or the like. The p-side electrode 16 may include a metal protective film (i.e. barrier metal) for suppressing sulfurization and oxidation thereof.

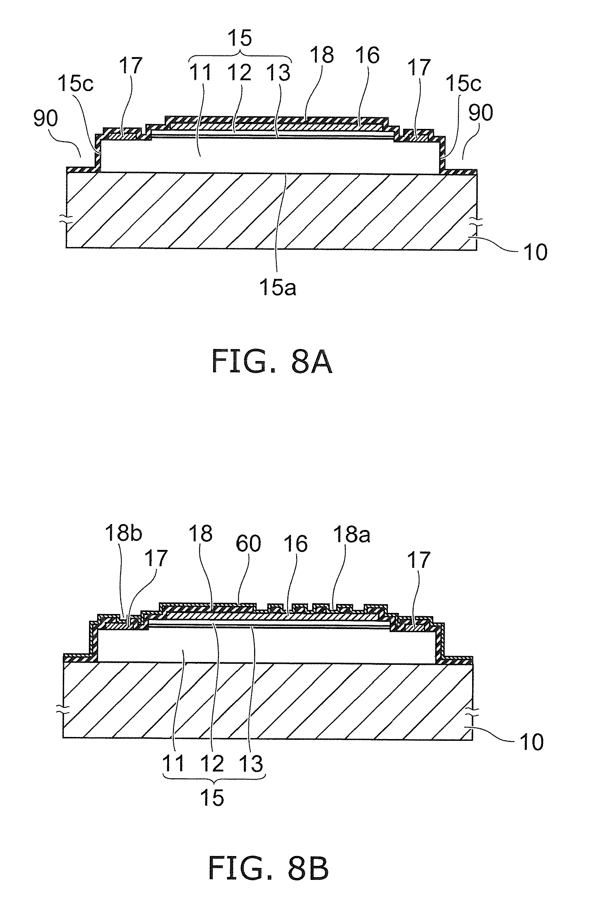

An insulating film 18 is formed to cover the structure formed on the substrate 10, as shown in FIG. 8A. The insulating film 18 covers the second surface 15b side, and the p-side electrode 16 and the n-side electrode 17. The insulating film 18 also covers side surfaces 15c joined to the first surface 15a. The insulating film 18 is also formed on a surface of the substrate 10 at the bottom of the trench 90.

The insulating film 18 is, for example, a silicon oxide film or silicon nitride film formed by CVD (chemical vapor deposition). As shown in FIG. 8B, the insulating film 18 has first openings 18a and a second opening 18b formed, for example, by wet etching using a resist mask. The first openings 18a are in communication with the p-side electrode 16, and the second opening 18b is in communication with the n-side electrode 17. Alternatively, a first opening 18a of larger size may be provided as a single opening over the p-side electrode 16.

Thereafter, as shown in FIG. 8B, a underlying metal layer 60 is formed on the insulating film 18, the inner surfaces (the side walls and bottom surfaces) of the first openings 18a, and the inner surface (the side wall and bottom surface) of the second opening 18b.

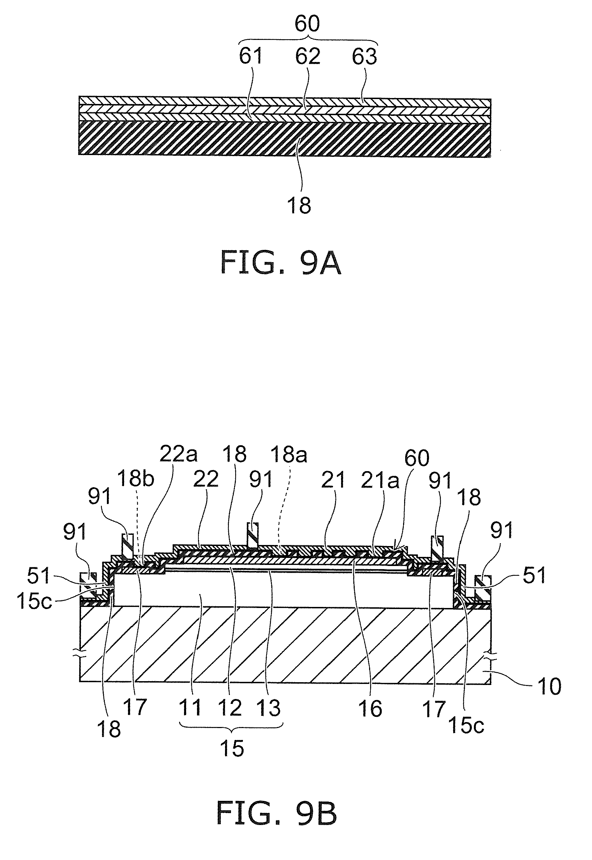

As shown in FIG. 9A, the underlying metal layer 60 includes an aluminum film 61, a titanium film 62, and a copper film 63. The aluminum film 61 serves as a reflecting film. The copper film 63 serves as a seed for plating. The titanium film 62 is suitable in wettability for both aluminum and copper, and serves as an adhesive layer. The underlying metal layer 60 is formed by, for example, sputtering.

A resist mask 91 is selectively formed on the underlying metal layer 60, as shown in FIG. 9B, and a p-side interconnection layer 21, an n-side interconnection layer 22, and a metal film 51 are formed by electrolytic copper plating, using the copper film 63 of the underlying metal layer 60 as a seed film.

The p-side interconnection layer 21 is also formed inside the first openings 18a, and is electrically connected to the p-side electrode 16. The n-side interconnection layer 22 is also formed inside the second opening 18b, and is electrically connected to the n-side electrode 17.

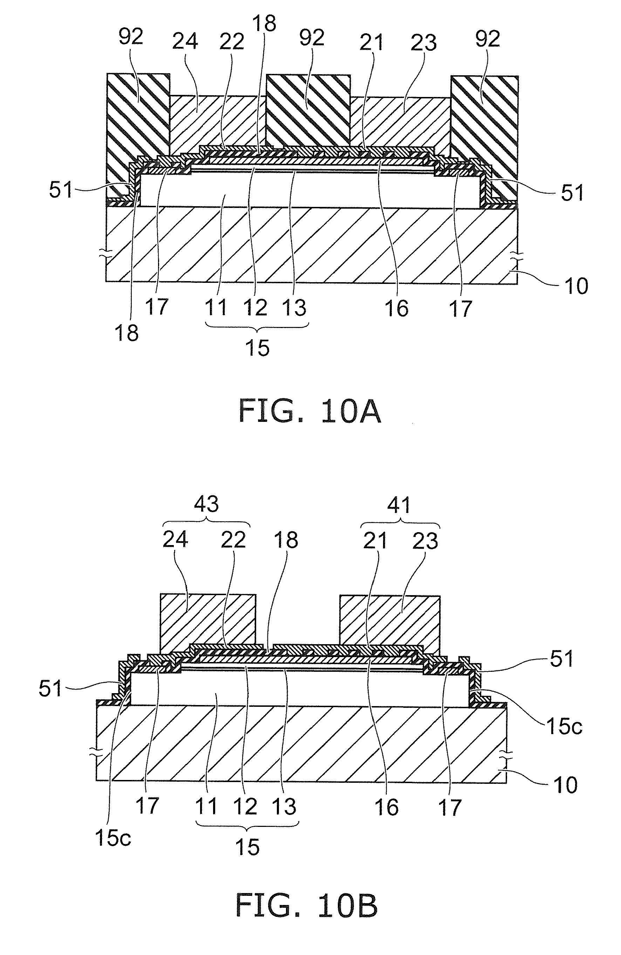

The resist mask 91 is removed by using, for example, a solvent or an oxygen plasma, and then, a resist mask 92 is selectively formed on the plating layers 21, 22 and 51, as shown in FIG. 10A. The resist mask 92 may be formed without removing the resist mask 91.

After forming the resist mask 92, a p-side metal pillar 23, and an n-side metal pillar 24 are formed by electrolytic copper plating, using the p-side interconnection layer 21 and the n-side interconnection layer 22 as seed layers.

The p-side metal pillar 23 is formed on the p-side interconnection layer 21. The p-side interconnection layer 21 and the p-side metal pillar 23 are joined into one body, when using the same copper material therefor. The n-side metal pillar 24 is formed on the n-side interconnection layer 22. The n-side interconnection layer 22 and the n-side metal pillar 24 are joined into one body when using the same copper material therefor.

The resist mask 92 is removed by a solvent or an oxygen plasma, for example. Here, the p-side interconnection layer 21 and the n-side interconnection layer 22 are electrically connected to each other via the underlying metal layer 60. The p-side interconnection layer 21 and the metal film 51 are also electrically connected to each other via the underlying metal layer 60. The n-side interconnection layer 22 and the metal film 51 are also electrically connected to each other via the underlying metal layer 60.

The underlying metal layer 60 is removed by etching in portions between the p-side interconnection layer 21 and the n-side interconnection layer 22, the p-side interconnection layer 21 and the metal film 51, and the n-side interconnection layer 22 and the metal film 51, as shown in FIG. 10B.

Thereby, the electrical connections vanishes between the p-side interconnection layer 21 and the n-side interconnection layer 22, the p-side interconnection layer 21 and the metal film 51, and the n-side interconnection layer 22 and the metal film 51.

The p-side interconnection layer 21 and the p-side metal pillar 23 form the p-side interconnect electrode 41. The n-side interconnection layer 22 and the n-side metal pillar 24 form the n-side interconnect electrode 43. The metal film 51 formed on the side surfaces 15c of the stacked body 15 is electrically floating, and does not serve as an electrode. The metal film 51 preferably serves as a reflecting film. The reflectivity of the metal film 51 may be increased by including at least the aluminum film 61.

By using copper as material of the p-side interconnect electrode 41 and the n-side interconnect electrode 43 as above, it is possible to achieve desirable heat conduction and high migration resistance, and improve adhesion for the insulating material. The embodiment is not limited to this example, and, for example, materials such as gold, nickel, and silver may be used for the p-side interconnect electrode 41 and the n-side interconnect electrode 43.

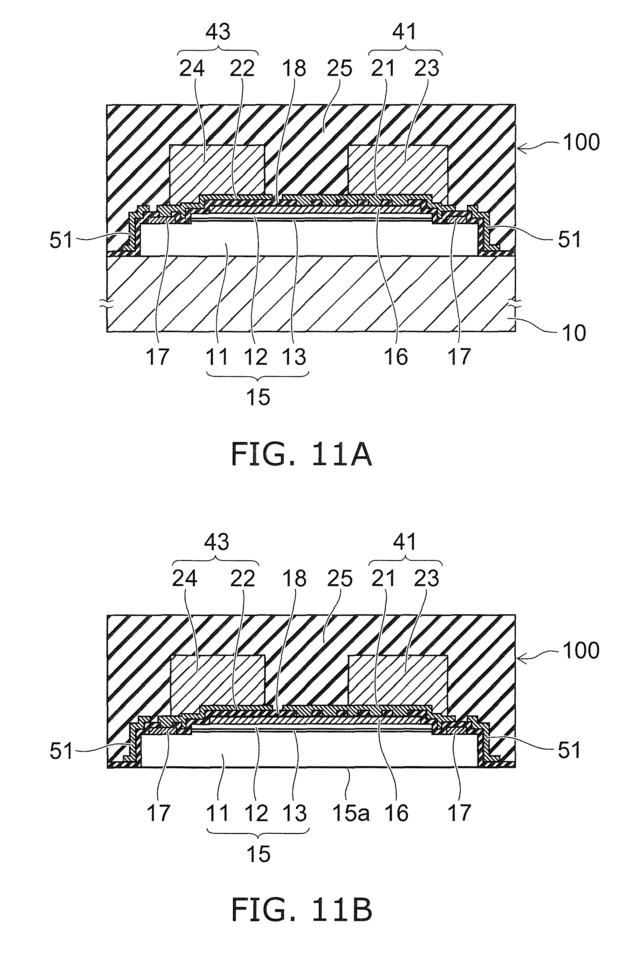

The resin layer 25 shown in FIG. 11A is formed on the structure shown in FIG. 10B. The resin layer 25 covers the p-side interconnect electrode 41 and the n-side interconnect electrode 43. The resin layer 25 also covers the metal film 51. The resin layer 25, together with the p-side interconnect electrode 41 and the n-side interconnect electrode 43, forms a support body 100 that supports the stacked body 15.

Desirably, materials having the same or similar coefficient of thermal expansion to the mounting substrate are used for the resin layer 25. Such material used for the resin layer 25 is primarily composed of epoxy resin, silicone resin, or fluororesin, for example. It is preferable to add a light shielding material (such as light absorbing particles, light reflecting particles, and light scattering particles) to the resin layer 25 to shield the emission from the light emitting layer 13. This makes it possible to suppress a light leak from the side surfaces and the mounting surface of the support body 100.

Thereafter, the substrate 10 is removed. The support body 100 maintains the stacked bodies 15 in a wafer shape. For example, the substrate (silicon substrate) 10 may be removed by wet etching or dry etching. Alternatively, a laser lift-off method may be used when the substrate 10 is a sapphire substrate.

The stacked body 15 on the substrate 10 may involve a large internal stress through the epitaxial growth. The p-side metal pillar 23, the n-side metal pillar 24, and the resin layer 25 are more flexible than the stacked body 15 made of, for example, a GaN material. Accordingly, the p-side metal pillar 23, the n-side metal pillar 24, and the resin layer 25 may absorb the internal stress, when removing the substrate 10. Hence, it is possible to avoid the stacked body 15 being damaged during the process of removing the substrate 10.

Removing the substrate 10 exposes the first surface 15a of the stacked body 15, as shown in FIG. 11B. Microscopic irregularities are formed on the first surface 15a. For example, the stacked body 15 is wet etched on the first surface 15a side with a KOH (potassium hydroxide) aqueous solution, TMAH (tetramethylammonium hydroxide), or the like. The etching rate thereof that depends on the crystal orientation of the stacked body 15 forms irregularities corresponding to the microscopic crystal structure in the first surface 15a. The microscopic irregularities on the first surface 15a may improve light extraction efficiency from the stacked body 15.

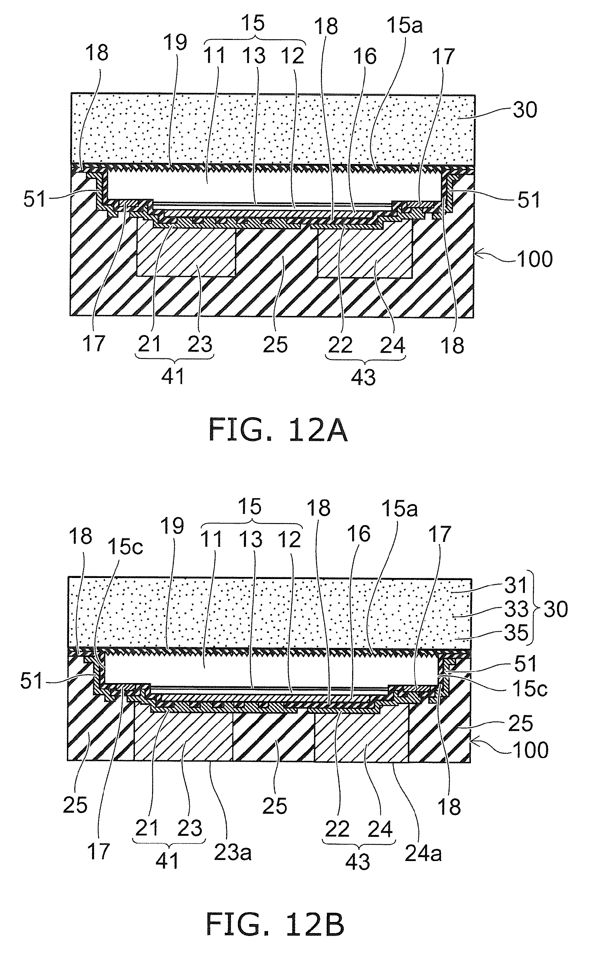

A phosphor layer 30 is formed on the first surface 15a via an insulating film 19 of material such as $SiO_2$ and SiN, as shown in FIG. 12A. The phosphor layer 30 includes at least the phosphor 31, as described above. The phosphor layer 30 may contain other phosphors, including the phosphor 33 described above.

The phosphor layer 30 is formed by using methods, for example, such as printing, potting, molding, and compression molding. The insulating film 19 improves the adhesion strength between the stacked body 15 and the phosphor layer 30. Alternatively, the phosphor layer 30 may be bonded via the insulating film 19, which is a sintered body prepared by sintering a phosphor with a binder, or a resin sheet including a phosphor.

The resin layer 25 is also provided around the side surfaces 15c of the stacked body 15. The phosphor layer 30 is formed extending on the region around the side surfaces 15c of the stacked body 15. Part of the phosphor layer 30 is formed on the resin layer 25 via the insulating films 18 and 19.

After forming the phosphor layer 30, the resin layer 25 is ground on a side opposite to the phosphor layer 30 to expose the p-side metal pillar 23 and the n-side metal pillar 24 in a surface of the resin layer 25 (the lower surface side in FIG. 12A), as shown in FIG. 12B. The exposed surface of the p-side metal pillar 23 is a p-side external terminal 23a, and the exposed surface of the n-side metal pillar 24 is an n-side external terminal 24a.

The wafer is divided into pieces by dicing along the trench 90 separating the stacked bodies 15 from each other. Specifically, the phosphor layer 30, the insulating film 19, the insulating film 18, and the resin layer 25 are cut, for example, by a dicing blade, or a laser beam. Since the stacked bodies 15 are absent in the dicing regions, it is possible to avoid the stacked body being damaged through the dicing process.

Each light emitting device 1 includes at least one stacked body 15. The light emitting device 1 may have a single-chip structure with one stacked body 15, or a multiple-chip structure with more than one stacked body 15. The light emitting device 1 according to the embodiment is a micro device that includes the stacked body 15 and the phosphor layer 30 in a chip size package.

In the foregoing steps before dividing into pieces, the stacked bodies 15 are maintained in the wafer shape. The manufacturing steps before the dicing are performed in the wafer state, and the dicing completes the light emitting device 1. This makes the manufacturing cost being greatly reduced.

When mounting the light emitting device 1 on a mounting substrate, the p-side external terminal 23a and the n-side external terminal 24a exposed in the surface of the resin layer 25 are bonded to land patterns on the mounting substrate, for example, via conductive materials such as solders. The p-side metal pillar 23, the n-side metal pillar 24, and the resin layer 25 may absorb and relieve the thermal cycle-induced stress between the light emitting device 1 and the mounting substrate. This enables to prevent the emission characteristics of the light emitting device 1 from deterioration, and improves the device reliability.

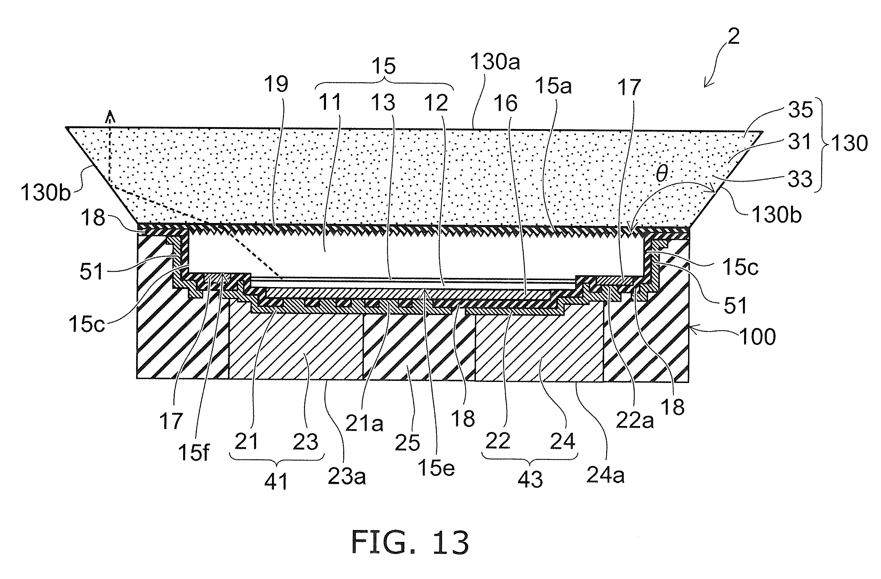

FIG. 13 is a schematic cross sectional view showing a light emitting device 2.

The light emitting device 2 includes a stacked body 15, and a phosphor layer 130 provided on a light emitting surface of the stacked body 15. It differs from the light emitting layer 1 in the shape of the phosphor layer 130.

A support body 100 including a p-side interconnect electrode 41, an n-side interconnect electrode 43, and a resin layer 25 is provided on the second surface 15b side of the stacked body 15. The support body 100 provided on the second surface 15b side supports the light emitting element (i.e. LED chip) containing the stacked body 15, the p-side electrode 16, and the n-side electrode 17.

The phosphor layer 130 includes, for example, phosphors 31 and 33 of particle shapes. The phosphors 31 and 33 are excited by light emitted from the light emitting layer 13, and emit lights with wavelengths different from that of light emitted from the light emitting layer 13. The phosphors 31 and 33 are joined into one body with a binder 35. The binder 35 transmits the lights emitted from the light emitting layer 13 and the phosphor 31. The word "transmit" here is not limited to transmit 100% of light, and may include the case where the light is partially absorbed in the binder 35.

As shown in FIG. 13, the phosphor layer 130 is provided so that side surfaces 130b are inclined with respect to the first surface 15a of the stacked body 15, and the upper surface 130a of the phosphor layer 130. The side surfaces 130b of the phosphor layer 130 form an obtuse angle with respect to the first surface 15a. Specifically, the inner angle $\theta$ created by the first surface 15a and the side surfaces 130b is greater than 90°.

In other words, the plane area of cross-section in parallel to the first surface 15a gradually increases in the phosphor layer 130 towards the upper surface 130a side from the first surface 15a side. The side surfaces 130b of the phosphor layer 130 are on the outer side than the side surfaces of the support body 100 (i.e. side surfaces of the resin layer 25) in the direction perpendicular to the first surface 15a. Such shape of the phosphor layer 130 may be formed by cutting the wafer, for example, with a blade having a V-shape tip.

The side surfaces 130b of the phosphor layer 130 are formed to be substantially flat without irregularities intended to improve light extraction efficiency by light scattering effect. Thus, the lights that are emitted from the light emitting layer 13 and the phosphor 31, and propagate towards the side surfaces 130b are incident on the side surfaces 130b at a larger angle, and thus, parts of the lights increases, which is totally reflected at the side surfaces 130a toward the upper surface 130a side. This makes it possible to increase light amount extracted from the upper surface 130a of the phosphor layer 130. It is also possible to reduce the light returning to the stacked body 15 from the phosphor layer 130, and suppress light loss absorbed in the stacked body 15, the metal, the insulating film, and the resin material. Further, by reducing light leak from the side surfaces 130b of the phosphor layer 130, it is possible to suppress color breaking and unevenness.

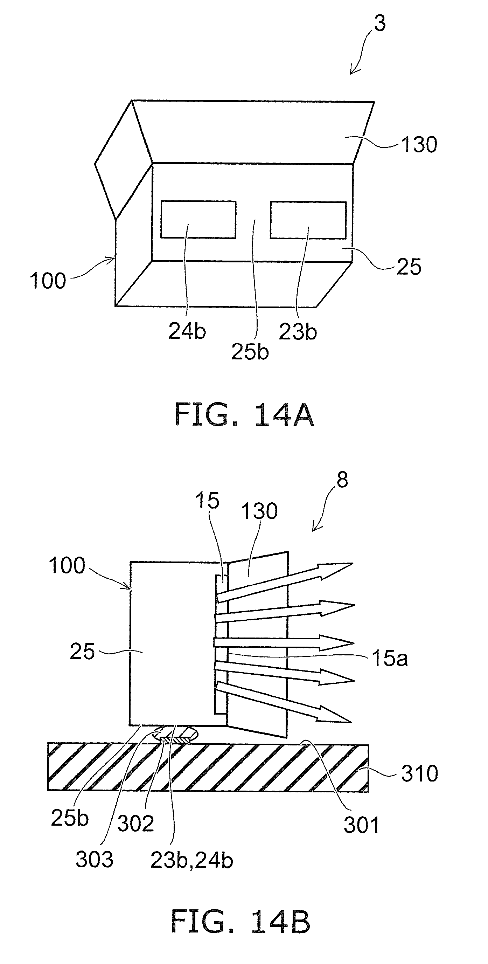

FIGS. 14A and 14B are schematic cross sectional views showing a light emitting device 3 according to a variation of the second embodiment.

FIG. 14A is a schematic perspective view of the light emitting device 3.

FIG. 14B is a schematic cross sectional view of a light emitting module including the light emitting device 3 mounted on a substrate 310.

The first embodiment is also applicable to the light emitting device 3 of a side-view type shown in FIGS. 14A and 14B. The light emitting device 3 has the same structure as the light emitting device 2, except for the exposed surfaces of the metal pillars 23 and 24 provided for external connections.

The side surface of the p-side meal pillar 23 is partially exposed from the resin layer 25 in a third surface 25b that has a plane orientation different from the first surface 15a of the stacked body 15 and the second surface 15b opposite to the first surface 15a. The exposed surface serves as a p-side external terminal 23b for mounting on an external substrate 310.

For example, the third surface 25b is a surface substantially perpendicular to the first surface 15a and the second surface 15b. For example, the resin layer 25 has four side surfaces, and one of these side surfaces is the third surface 25b.

The side surface of the n-side metal pillar 24 is partially exposed from the resin layer 25 in the third surface 25b. The exposed surface serves as an n-side external terminal 24b for mounting on the external substrate 310.

The p-side metal pillar 23 is covered with the resin layer 25 except for the p-side external terminal 23b exposed on the third surface 25b. The n-side metal pillar 24 is covered with the resin layer 25 except for the n-side external terminal 24b exposed on the third surface 25b.

The light emitting device 3 is mounted with the third surface 25b facing the mounting surface 301 of the substrate 310, as shown in FIG. 14B. The p-side external terminal 23b and the n-side external terminal 24b exposed on the third surface 25b are bonded to pads 302 provided on the mounting surface 301, using a solder 303. The substrate 310 also includes, for example, a wiring pattern provided on the mounting surface 301, and leading to an external circuit. The wiring pattern connects the pads 302 and the external circuit.

The third surface 25b is substantially perpendicular to the first surface 15a that is the light emitting surface. The first surface 15a thus faces a lateral direction parallel to the mounting surface 301, or a direction tilted with respect to the mounting surface 301, wherein the third surface 25b faces the mounting surface 301. That is, The light emitting device 3 is the side view-type light emitting device which emits light in a lateral direction parallel to the mounting surface 301, or in an oblique direction with respect to the mounting surface 301.

The phosphor layer 130 shown on FIGS. 14A and 14B may be replaced by the phosphor layer 30 of the first embodiment. That is, the phosphor layer 130 may also include phosphors cited in the first embodiment.

The "nitride semiconductor" referred to herein includes group III-V compound semiconductors of $B_xIn_yAl_zGa_{1-x-y-z}N$ ($0 \leq x \leq 1$, $0 \leq y \leq 1$, $0 \leq z \leq 1$, $0 \leq x+y+z \leq 1$), and also includes mixed crystals containing a group V element besides N (nitrogen), such as phosphorus (P) and arsenic (As). Furthermore, the "nitride semiconductor" also includes those further containing various elements added to control various material properties such as conductivity type, and those further containing various unintended elements.

While certain embodiments have been described, these embodiments have been presented by way of example only, and are not intended to limit the scope of the inventions. Indeed, the novel embodiments described herein may be embodied in a variety of other forms. The accompanying claims and their equivalents are intended to cover such forms or modifications as would fall within the scope of the invention.

**Claims**

1. A light emitting device (1, 2, 3) comprising:

   a light emitter (15) having an emission peak in a wavelength range of not less than 360 nanometers and not more than 470 nanometers; and
   a first phosphor (31) having a composition represented by the chemical formula of $Ca_{8-x}Eu_xMg_{1-y}Mn_y(SiO_4)_4Cl_2$ wherein $0 < x \leq 8$, $0 < y \leq 1$.

2. The device according to claim 1, wherein the proportion y of manganese contained in the first phosphor (31) is not more than 0.2.

3. The device according to claim 1, further comprising a second phosphor (33) having an emission peak in a wavelength range longer than 555 nanometers.

4. The device according to claim 3, further comprising a layer covering the light emitter (15), wherein the layer includes the first phosphor (31) and the second phosphor (33).

5. The device according to claim 3, wherein the emission peak of the second phosphor (33) is in a wavelength range of not less than 580 nanometers and not more than 600 nanometers.

6. The device according to claim 3, wherein the second phosphor (33) contains a phosphor of strontium silicate system.

7. The device according to claim 3, wherein the second phosphor (33) contains a phosphor represented by a chemical formula of $(Sr_{1-x-y}Ba_yEu_x)_3 (Si_{1-z}Ge_z)O_5$, wherein $0 < x \leq 0.1$, $0 \leq y \leq 1$, and $0 \leq z \leq 0.1$.

8. A light emitting device (1, 2, 3) comprising:

   a light emitter (15) having an emission peak in a wavelength range shorter than 360 nanometers;
   a first phosphor (31) having a composition represented by the chemical formula of $Ca_{8-x}Eu_xMg_{1-y}Mn_y(SiO_4)_4Cl_2$ wherein $0 < x \leq 8$, $0 < y \leq 1$, and having an emission peak in a wavelength range of not less than 500 nanometers and not more than 555 nanometers; and
   a second phosphor (33) having an emission peak in a wavelength range longer than 555 nanometers.

9. The device according to claim 8, wherein the proportion y of manganese contained in the first phosphor (31) is not more than 0.2.

10. The device according to claim 8, wherein the emission peak of the second phosphor (33) is in a wavelength range of not less than 580 nanometers and not more than 600 nanometers.

11. The device according to claim 8, further comprising a third phosphor (33) having an emission peak in a wavelength range of not less than 430 nanometers and not more than 480 nanometers.

12. The device according to claim 8, wherein the second phosphor (33) contains a phosphor represented by a chemical formula of $(Sr_{1-x-y}Ba_yEu_x)_3 (Si_{1-z}Ge_z)O_5$, wherein $0 < x \leq 0.1$, $0 \leq y \leq 1$, and $0 \leq z \leq 0.1$.

**Patentansprüche**

1. Lichtemittierende Vorrichtung (1, 2, 3), umfassend:

   einen Lichtemitter (15), der ein Emissionsmaximum in einem Wellenlängenbereich von nicht weniger als 360 Nanometer und nicht mehr als 470 Nanometer aufweist; und
   einen ersten Leuchtstoff (31) mit einer Zusammensetzung mit der chemischen Formel $Ca_{8-x}Eu_xMg_{1-y}Mn_y(SiO_4)_4Cl_2$, worin $0 < x \leq 8$, $0 < y \leq 1$ ist.

**2.** Vorrichtung gemäß Anspruch 1, wobei der Anteil y des in dem ersten Leuchtstoff (31) enthaltenen Mangans nicht mehr als 0,2 ist.

**3.** Vorrichtung gemäß Anspruch 1, zusätzlich umfassend einen zweiten Leuchtstoff (33) mit einem Emissionsmaximum in einem Wellenlängenbereich länger als 555 Nanometer.

**4.** Vorrichtung gemäß Anspruch 3, zusätzlich umfassend eine Schicht, die den Lichtemitter (15) bedeckt, wobei die Schicht den ersten Leuchtstoff (31) und den zweiten Leuchtstoff (33) beinhaltet.

**5.** Vorrichtung gemäß Anspruch 3, wobei das Emissionsmaximum des zweiten Leuchtstoffs (33) in einem Wellenlängenbereich von nicht weniger als 580 Nanometer und nicht mehr als 600 Nanometer liegt.

**6.** Vorrichtung gemäß Anspruch 3, wobei der zweite Leuchtstoff (33) einen Leuchtstoff aus einem Strontiumsilicat-System enthält.

**7.** Vorrichtung gemäß Anspruch 3, wobei der zweite Leuchtstoff (33) einen Leuchtstoff mit einer chemischen Formel $(Sr_{1-x-y}Ba_yEu_x)_3 (Si_{1-z}Ge_z)O_5$ enthält, worin $0 < x \le 0,1$, $0 \le y \le 1$ und $0 \le z \le 0,1$ ist.

**8.** Lichtemittierende Vorrichtung (1, 2, 3), umfassend:

einen Lichtemitter (15), der ein Emissionsmaximum in einem Wellenlängenbereich kürzer als 360 Nanometer aufweist;
einen ersten Leuchtstoff (31) mit einer Zusammensetzung mit der chemischen Formel $Ca_{8-x}Eu_xMg_{1-y}Mn_y(SiO_4)_4Cl_2$, worin $0 < x \le 8$, $0 < y \le 1$ ist, mit einem Emissionsmaximum in einem Wellenlängenbereich von nicht weniger als 500 Nanometer und nicht mehr als 555 Nanometer; und
einen zweiten Leuchtstoff (33) mit einem Emissionsmaximum in einem Wellenlängenbereich länger als 555 Nanometer.

**9.** Vorrichtung gemäß Anspruch 8, wobei der Anteil y des in dem ersten Leuchtstoff (31) enthaltenen Mangans nicht mehr als 0,2 ist.

**10.** Vorrichtung gemäß Anspruch 8, wobei das Emissionsmaximum des zweiten Leuchtstoffs (33) in einem Wellenlängenbereich von nicht weniger als 580 Nanometer und nicht mehr als 600 Nanometer liegt.

**11.** Vorrichtung gemäß Anspruch 8, zusätzlich umfassend einen dritten Leuchtstoff (33) mit einem Emissionsmaximum in einem Wellenlängenbereich von nicht weniger als 430 Nanometer und nicht mehr als 480 Nanometer.

**12.** Vorrichtung gemäß Anspruch 8, wobei der zweite Leuchtstoff (33) einen Leuchtstoff mit einer chemischen Formel $(Sr_{1-x-y}Ba_yEu_x)_3(Si_{1-z}Ge_z)O_5$ enthält, worin $0 < x \le 0,1$, $0 \le y \le 1$ und $0 \le z \le 0,1$ ist.

**Revendications**

**1.** Dispositif électroluminescent (1, 2, 3), comprenant :

un photoémetteur (15) ayant un pic d'émission situé dans une plage de longueurs d'ondes allant de 360 nanomètres à 470 nanomètres ; et
un premier phosphore (31) ayant une composition représentée par la formule chimique $Ca_{8-x}Eu_xMg_{1-y}Mn_y(SiO_4)_4Cl_2$ dans laquelle $0 < x \le 8$, $0 < y \le 1$.

**2.** Dispositif selon la revendication 1, dans lequel la proportion y de manganèse contenue dans le premier phosphore (31) n'est pas supérieure à 0,2.

**3.** Dispositif selon la revendication 1, comprenant en outre un deuxième phosphore (33) ayant un pic d'émission situé dans une plage de longueurs d'ondes supérieures à 555 nanomètres.

**4.** Dispositif selon la revendication 3, comprenant en outre une couche recouvrant le photoémetteur (15), dans lequel la couche comprend le premier phosphore (31) et le deuxième phosphore (33).

**5.** Dispositif selon la revendication 3, dans lequel le pic d'émission du deuxième phosphore (33) est situé dans une plage de longueurs d'ondes allant de 580 nanomètres à 600 nanomètres.

**6.** Dispositif selon la revendication 3, dans lequel le deuxième phosphore (33) contient un phosphore d'un système de silicate de strontium.

**7.** Dispositif selon la revendication 3, dans lequel le deuxième phosphore (33) contient un phosphore représenté par une formule chimique $(Sr_{1-x-y}Ba_yEu_x)_3 (Si_{1-z}Ge_z)O_5$, dans laquelle $0 < x \le 0,1$, $0 \le y \le 1$ et $0 \le z \le 0,1$.

**8.** Dispositif électroluminescent (1, 2, 3), comprenant :

un photoémetteur (15) ayant un pic d'émission situé dans une plage de longueurs d'ondes inférieures à 360 nanomètres ;
un premier phosphore (31) ayant une composition représentée par la formule chimique $Ca_{8-x}Eu_xMg_{1-y}Mn_y(SiO_4)_4Cl_2$ dans laquelle $0 < x \le 8$, $0 < y \le 1$, et
ayant un pic d'émission situé dans une plage de longueurs d'ondes allant de 500 nanomètres à 555 nanomètres ; et
un deuxième phosphore (33) ayant un pic d'émission situé dans une plage de longueurs d'ondes supérieures à 555 nanomètres.

9. Dispositif selon la revendication 8, dans lequel la proportion y de manganèse contenue dans le premier phosphore (31) n'est pas supérieure à 0,2.

10. Dispositif selon la revendication 8, dans lequel le pic d'émission du deuxième phosphore (33) est situé dans une plage de longueurs d'ondes allant de 580 nanomètres à 600 nanomètres.

11. Dispositif selon la revendication 8, comprenant en outre un troisième phosphore (33) ayant un pic d'émission situé dans une plage de longueurs d'ondes allant de 430 nanomètres à 480 nanomètres.

12. Dispositif selon la revendication 8, dans lequel le deuxième phosphore (33) contient un phosphore représenté par une formule chimique $(Sr_{1-x-y}Ba_yEu_x)_3(Si_{1-z}Ge_z)O_5$, dans laquelle $0 < x \leq 0,1$, $0 \leq y \leq 1$, et $0 \leq z \leq 0,1$.

FIG. 1

FIG. 2A

FIG. 2B

FIG. 3

FIG. 4

FIG. 5A

FIG. 5B

115
11 12 13   15b

15a

FIG. 6A

115
11 12 13

10

FIG. 6B

FIG. 7A

FIG. 7B

FIG. 8A

FIG. 8B

FIG. 9A

FIG. 9B

FIG. 10A

FIG. 10B

FIG. 11A

FIG. 11B

FIG. 12A

FIG. 12B

FIG. 13

EP 2 918 655 B1

3

130

100

25

24b     25b     23b

# FIG. 14A

8

15     130

100

25

15a

310

25b     302     301

303     23b,24b

# FIG. 14B

FIG. 15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2003006469 A1
- US 2007247829 A1
- US 2012126253 A1
- US 2006284185 A1